# EUROPEAN PATENT APPLICATION

(11) **EP 2 487 724 A2**
(43) Date of publication of application: **15.08.2012**
(21) Application number: 10822255.5
(22) Date of filing: 07.10.2010
(51) Int. Cl.: H01L 31/042

(54) **PHOTOVOLTAIC POWER-GENERATING APPARATUS AND METHOD FOR MANUFACTURING SAME**

(30) Priority: 07.10.2009 KR 20090094991
(71) Applicant: LG Innotek Co., Ltd., Seoul 100-714 (KR)
(72) Inventor: CHOI, Chul Hwan, Seoul 100-714 (KR)
(74) Representative: Novagraaf Technologies
(86) International application number: PCT/KR2010/006870
(87) International publication number: WO 2011/043610

(57) **Abstract**

Provided are a photovoltaic apparatus and a manufacturing method thereof. The photovoltaic apparatus includes: substrate; a back electrode layer disposed on the substrate; a plurality of first intermediate layers disposed on the back electrode layer; a plurality of second intermediate layers disposed on the back electrode layer and each disposed between the first intermediate layers; light absorbing layers disposed on the first intermediate layers and the second intermediate layers; and a front electrode layer disposed on the light absorbing layer.

## Description

### Technical Field

The present invention relates to a photovoltaics apparatus and a manufacturing method thereof.

### Background Art

Recently, with the increase in an energy demand, a development for converting solar energy into electric energy has been progressed.

In particular, a pn hetero junction apparatus, that is, a CIGS-based solar cell having a substrate structure including a glass substrate, a metal back electrode layer, a p-type CIGS-based light absorbing layer, a high resistive buffer layer, an n-type window layer, or the like, has been prominently used.

The solar cell is formed by connecting a plurality of cells to one another. Research for improving electrical characteristics of each cell has been conducted.

### Disclosure

### Technical Problem

An advantage of some aspects of the invention is that it provides a photovoltaics apparatus and a manufacturing method thereof capable of improving electrical characteristics.

### Technical Solution

According to an exemplary embodiment of the present invention, there is provided a photovoltaics apparatus, including: a substrate; a back electrode layer disposed on the substrate; a plurality of first intermediate layers disposed on the back electrode layer; a plurality of second intermediate layers disposed on the back electrode layer and each disposed between the first intermediate layers; light absorbing layers disposed on the first intermediate layers and the second intermediate layers; and a front electrode layer disposed on the light absorbing layer.

According to another exemplary embodiment of the present invention, there is provided a photovoltaics apparatus, including: a substrate; a first cell and a second cell disposed on the substrate; and connection wirings connecting a first front electrode of the first cell with the a second back electrode of the second cell, wherein the second cell includes: the second back electrode; a second light absorbing unit disposed on the second back electrode; a second front electrode disposed on the second light absorbing unit; a first intermediate layer disposed between the second back electrode and the second light absorbing unit; and a second intermediate layer disposed between the connection wiring and the second back electrode.

According to an another exemplary embodiment of the present invention, there is provided a method for manufacturing a photovoltaics apparatus, including: forming a back electrode layer on a substrate; forming a light absorbing layer on the back electrode layer; forming an intermediate layer between the back electrode layer and the light absorbing layer; forming a through hole penetrating through the light absorbing layer; a second intermediate layer by crystallizing an intermediate layer exposed by the through hole; and forming a front electrode layer on the light absorbing layer.

### Advantageous Effects

According to the exemplary embodiments of the present invention, the first intermediate layer and the second intermediate layer having different electric conductivity can be selectively formed on the back electrode layer. In particular, the second intermediate layer can have higher electric conductivity than the first intermediate layer.

Therefore, the connection wiring extending from the front electrode layer contacts the back electrode layer through the second intermediate layer, thereby reducing the contact resistance. As a result, the electrical characteristics of the photovoltaics apparatus according to the exemplary embodiments of the present invention can be improved.

Further, the second intermediate layer may be simultaneously formed during the scribing process for forming the through holes in the light absorbing layer.

That is, the crystallinity of the second intermediate layer can be increased and the conductivity can be improved by performing the heat treatment process and the scribing process on the second intermediated layer that is the bottom surface of the through hole.

In particular, the second intermediate layer can be formed by applying heat to the first intermediate layer through the tip used for the scribing process. In this case, the grain size of the second intermediate layer can be further increased and thus, the electric conductivity of the second intermediate layer can be improved.

### Description of Drawings

FIG. 1 is a plan view showing a photovoltaics apparatus according to an exemplary embodiment of the present invention.
FIG. 2 is a cross- sectional view taken along line A-A'of FIG. 1.
FIG. 3 is a cross-sectional view showing a crystal structure of a first intermediate layer and a second intermediate layer.
FIGS. 4 to 11 are diagrams showing a process of manufacturing a photovoltaics apparatus according to the exemplary embodiments of the present invention.

### Mode for Invention

Hereinafter, an exemplary embodiment of the disclosure will be described in detail with reference to drawings. However, the disclosure cannot be limited to the embodiment in which the idea of the disclosure is presented, another embodiment included within range of idea of another backward disclosure or the closure may be easily proposed by addition, change, deletion and the like of another constituent.

In the description of the embodiment, in a case where each substrate, layer, a film or a electrode and the like is described to be formed 'on' or 'under' thereof, 'on' or 'under' also means one to be formed 'directly' or 'indirectly'(through other component) to component. Also, the criteria regarding 'on' or 'under' of each component will be described based on the drawings. In the drawing, the size of each component may be exaggerated to describe, and does not mean the size that is in fact applied.

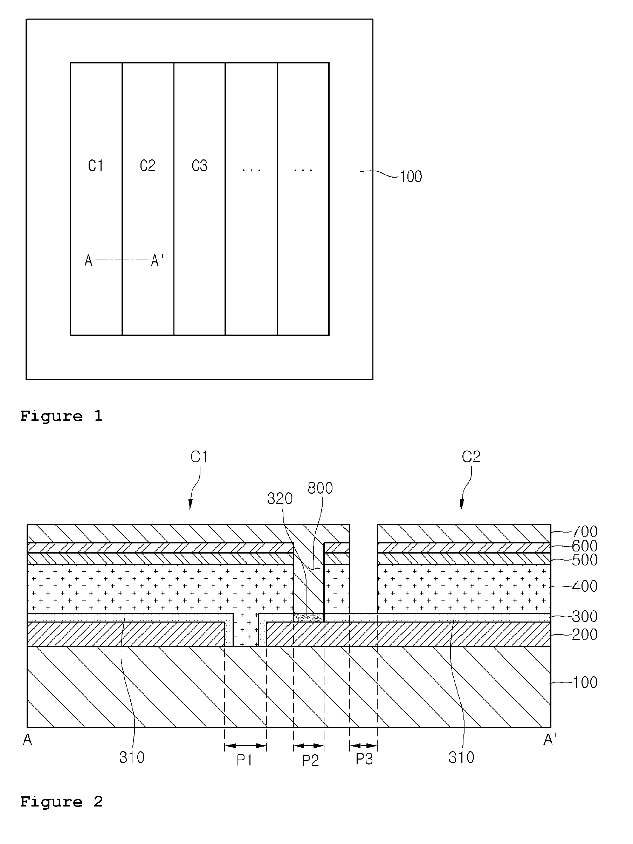

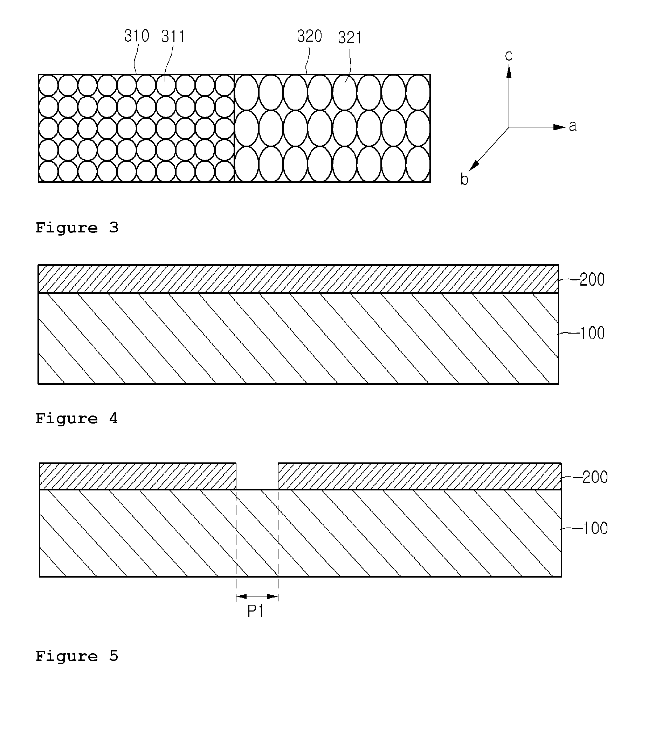

FIG. 1 is a plan view showing a solar cell panel according to an exemplary embodiment of the present invention. FIG. 2 is a cross-sectional view taken along line A-A' of FIG. 1; FIG. 3 is a cross-sectional view showing a crystal structure of a first intermediate layer and a second intermediate layer.

Referring to FIGS. 1 to 3, the solar cell panel according to the exemplary embodiment of the present invention may include a substrate 100, a back electrode layer 200, an intermediate layer 300, a light absorbing layer 400, a buffer layer 500, a high resistive buffer layer 600, a front electrode layer 700, and a plurality of connection wirings 800.

The substrate 100 has a plate shape and supports the back electrode layer 200, the intermediate layer 300, the light absorbing layer 400, the buffer layer 500, the high resistive buffer layer 600, the front electrode layer 700, and the connection wirings 800.

The substrate 100 may be an insulator. The substrate 100 may be a glass substrate, a plastic substrate, or a metal substrate. In detail, the substrate 100 may be a soda lime glass substrate. The substrate 100 may be transparent. The substrate 100 may be rigid or flexible.

The back electrode layer 200 is disposed on the substrate 100. The back electrode layer 200 is a conductive layer. An example of a material used as the back electrode layer 200 may include metals such as molybdenum, or the like.

In addition, the back electrode layer 200 may include two or more layers. In this case, each layer may be made of the same metal or different metals.

The back electrode layer 200 is provided with first through holes P1. The first through holes P1 is an open region exposing a top surface of the substrate 100. The first through holes P1 may have a shape extending in one direction when viewed from a top.

A width of the first through holes P1 may be about 80 µm to 200 µm.

The back electrode layer 200 may be divided into a plurality of back electrodes by the first through holes P1. That is, the back electrodes are defined by the first through holes P1.

The back electrodes are spaced apart from each other by the first through holes P1. The back electrodes are disposed in a stripe type.

Differently from this, the back electrodes may be disposed in a matrix type. In this case, the first through holes P1 may be formed in a lattice type when viewed from a top.

The intermediate layer 300 is disposed on the back electrode layer 200. The intermediate layer 300 is disposed between the back electrode layer 200 and the light absorbing layer 400. The intermediate layer 300 directly contacts the back electrode layer 200 and the light absorbing layer 400.

In addition, the intermediate layer 300 covers an inner side of the fist through holes P1. In this case, the intermediate layer 300 is not formed on the top surface of the exposed substrate 100 by the first through holes P1. The intermediate layer 300 may be an interface layer formed at the interface between the back electrode layer 200 and the light absorbing layer 400.

The intermediate layer 300 may include compounds of the materials included in the back electrode layer 200 and materials included in the light absorbing layer 400. In more detail, the intermediate layer 300 may be made of MoSe₂. The intermediate layer 300 may include compounds of the molybdenum included in the back electrode layer 200 and selenium included in the light absorbing layer 400.

The intermediate layer 300 includes a plurality of first intermediate layers 310 and a plurality of second intermediate layers 320.

The first intermediate layers 310 and the second intermediate layers 320 are alternately disposed with each other. That is, the second intermediate layers 320 are each disposed between the first intermediate layers 310. In addition, the first intermediate layers 310 are each disposed between the second intermediate layers 310.

The first intermediate layers 310 and the second intermediate layers 320 are disposed on the top surface of the back electrode layer 200. The first intermediate layers 310 and the second intermediate layers 320 are disposed on a co-plane. That is, the first intermediate layers 310 and the second intermediate layers 320 are disposed on the same layer. In addition, the sides of the first intermediate layer 310 may contact the sides of the second intermediate layers 320.

The light absorbing layer 400 is disposed on the intermediate layer 300. The light absorbing layer 400 may directly contact the intermediate layer 300. In addition, the materials included in the light absorbing layer 400 are filled in the first through holes P1.

The light absorbing layer 400 includes I-group elements, III-group elements, and IV-group elements. In more detail, the light absorbing layer 400 includes I-III-VI-group compounds. For example, the light absorbing layer 400 may have a cooper-indium-gallium-selenide-based (Cu(In,Ga)Se₂ (CIGS)-based) crystal structure and a copper-indium-selenide-based or copper-gallium-selenide-based crystal structure.

An energy bandgap of the light absorbing layer 400 may be about 1eV to 1.8eV.

Further, the light absorbing layer 400 defines the plurality of light absorbing parts by the second through holes P2. That is, the light absorbing layer 400 is divided into the plurality of light absorbing parts by the second through holes P2.

The buffer layer 500 is disposed on the light absorbing layer 400. The buffer layer 500 includes cadmium sulfide (CdS) and the energy band gap of the buffer layer 500 is about 2.2eV to 2.4eV.

The high resistive buffer layer 600 is disposed on the buffer layer 500. The high resistive buffer layer 600 includes zinc oxide (i-ZnO) that is not doped with impurity. The energy band gap of the high resistive buffer layer 600 is about 3.1eV to 3.3eV.

The light absorbing layer 400, the buffer layer 500, and the high resistive buffer layer 600 are provided with the second through holes P2. The second through holes P2 penetrates through the light absorbing layer 400. Further, the second through holes P2 is an open region that exposes the top surface of the intermediate layer 300.

The second through holes P2 are adjacently formed to the first though holes P1. That is, a portion of the second through holes P2 is formed beside the first through holes P1 when viewed from a top.

A width of the second through holes P1 may be about 80 µm to 200 µm.

The front electrode layer 700 is disposed on the high resistive buffer layer layer 600. The front electrode layer 700 is a transparent, conductive layer.

The front electrode layer 700 includes oxide. For example, the front electrode layer 700 may include aluminum doped zinc oxide (AZO), gallium doped zinc oxide (GZO), or the like.

In addition, the front electrode layer 700 is divided into a plurality of front electrodes by the third through holes P3. That is, the front electrodes are defined by the third through holes P3.

The front electrodes have a shape corresponding to the back electrodes. That is, the front electrodes are disposed in a stripe type. Differently from this, the front electrodes may be disposed in a matrix type.

In addition, the plurality of cells C1, C2, ?are defined by the third through holes P3. In more detail, the cells C1, C2, ?are defined by the second through holes P2 and the third through holes P3. That is, the photovaltaics apparatus according to the exemplary embodiment of the present invention is divided into the cells C1, C2, ?by the second through holes P2 and the third through holes P3.

The connection wirings 800 are each disposed in the second through holes P2. The connection wirings 800 are integrally formed with the front electrode layer 700. The connection wirings 800 extend downwardly from the front electrode layer 700.

The first intermediate layers 310 each correspond to the light absorbing parts. The second intermediate layers 320 each correspond to the second through holes P2. The second intermediate layers 320 each correspond to the bottom surfaces of the second through holes P2. Boundaries between the first intermediate layers 310 and between the second intermediate layers 320 may each correspond to the inner sides of the second through holes P2.

In addition, the second intermediate layers 200 are each disposed between the connection wirings 800 and the back electrode layer 200. In addition, the second intermediate layers 320 directly contact the connection wirings 800 and the back electrode layer 200.

The connection wirings 800 are connected with the back electrode layer 200 through the second intermediate layers 320. That is, the connection wirings 800 are directly connected with the second intermediate layers 320. For example, the single connection wiring 800 extends from the front electrode of the first cell C1 and is thus connected with the back electrode of the second cell C2 through the second intermediate layer 300 of the second cell C2.

Therefore, the connection wirings 800 connect the adjacent cells to each other. In more detail, the connection wirings 800 connect the front electrode and the back electrode that are each included in the adjacent cells C1, C2... each other.

FIG. 2 shows the connection structrue of the first cell C1 and the second cell C2. Referring to FIG. 2, the first cell C1 includes the back electrode, the first intermediate layer, the light absorbing part, the buffer layer, the high resistive buffer layer, and the front electrode that are sequentially stacked on the substrate 100.

In addition, the second cell C2 includes the back electrode, the first intermediate layer, the light absorbing part, the buffer layer, the high resistive buffer layer, and the front electrode that are sequentially stacked on the substrate 100.

The front electrode of the first cell C1 is connected with the back electrode of the second cell C2. In more detail, the front electrode of the first cell C1 is connected with the back electrode of the second cell C2 through the connection wiring 800 and the intermediate layer of the second cell C2.

The second intermediate layer of the second cell C2 is disposed beside the first intermediate layer of the second cell C2 and is disposed on the back electrode of the second cell C2.

A connection structure of other cells C3, C4,..may be as shown in FIG. 2. That is, even in other cells C3, C4,.., the connection structure of FIG. 2 may be continuously repeated.

The connection wirings 800 are integrally formed with the front electrode layer 700. That is, the materials used as the connection wirings 800 are equal to the materials used as the front electrode layer 700.

As shown in FIG. 3, the second intermediate layers 320 may be made of the same material as the first intermediate layer 300. The second intermediate layers 320 have a crystal structure different from the first intermediate layers 310.

In more detail, the second intermediate layers 320 have grain sizes larger than the first intermediate layers 310. For example, the grain sizes of the second intermediate layers 320 may be two to five times larger than those of the first intermediate layers 310.

Therefore, the second intermediate layers 320 have electric conductivity larger than the first intermediate layers 310. That is, the second intermediate layers 320 have resistance lower than the first intermediate layers 310.

Therefore, the connection wirings 800 are connected with the back electrode layer 200 through the second intermediate layers 320, such that the contact resistance between the connection wirings 800 and the back electrode layer 200 may be low.

As a result, the photovoltaics apparatus to the exemplary embodiment of the present invention may have the improved electrical characteristics and the improved photoelectric conversion efficiency.

FIGS. 4 to 11 are diagrams showing a method for manufacturing a photovoltaics apparatus according to the exemplary embodiments of the present invention. The description of the manufacturing method refers to the above-mentioned photovoltaics apparatus. That is, the description of the above-mentioned photovoltaics apparatus may be essentially coupled with the description of the manufacturing method.

Referring to FIG. 4, the back electrode layer 200 is formed on the substrate 100.

The substrate 100 may be made of glass and the ceramic substrate, the metal substrate, or the polymer substrate, or the like, may be used.

For example, as the glass substrate, sodalime glass or high strained point soda glass may be used. As the metal substrate, a substrate including stainless steel or titanium may be used. As the polymer substrate, polyimide may be used.

The substrate 100 may be transparent. The substrate 100 may be rigid or flexible.

The back electrode layer 200 may be formed of a conductor such as metal.

For example, the back electrode layer 200 may be formed by a sputtering process, using molybdenum (Mo) as a target.

This is due to the high electric conductivity of the molybdenum (Mo), the ohmic contact with the light absorbing layer 400, the high temperature stability under Se atmosphere.

The molybdenum thin film that is the back electrode layer 200 has low specific resistance as an electrode and has excellent adhesion with the substrate 100 so as not to cause a delamination phenomenon due to the difference in the thermal expansion coefficients.

Meanwhile, the materials forming the back electrode layer 200 is not limited thereto and may be made of molybdenum (Mo) doped with sodium (Na) ions.

Although not shown, the back electrode layer 200 may be made of at least one layer. When the back electrode layer 200 is formed in a plurality of layers, the layers forming the back electrode layer 200 may be made of different materials.

Referring to FIG. 5, the back electrode layer 200 is formed with the first through holes P1 and the back electrode layer 200 may be patterned with the plurality of back electrodes. The first through holes P1 may selectively expose a top surface of the substrate 100.

For example, the first through holes P1 may be patterned by a mechanical apparatus or a laser apparatus. A width of the first through holes P1 may be about 80µm±20.

The back electrode layer 200 may be disposed in a stripe type or a matrix type by the first through holes P1 and may correspond to each cell.

Meanwhile, the back electrode layer 200 is not limited to the type and may be formed in various forms.

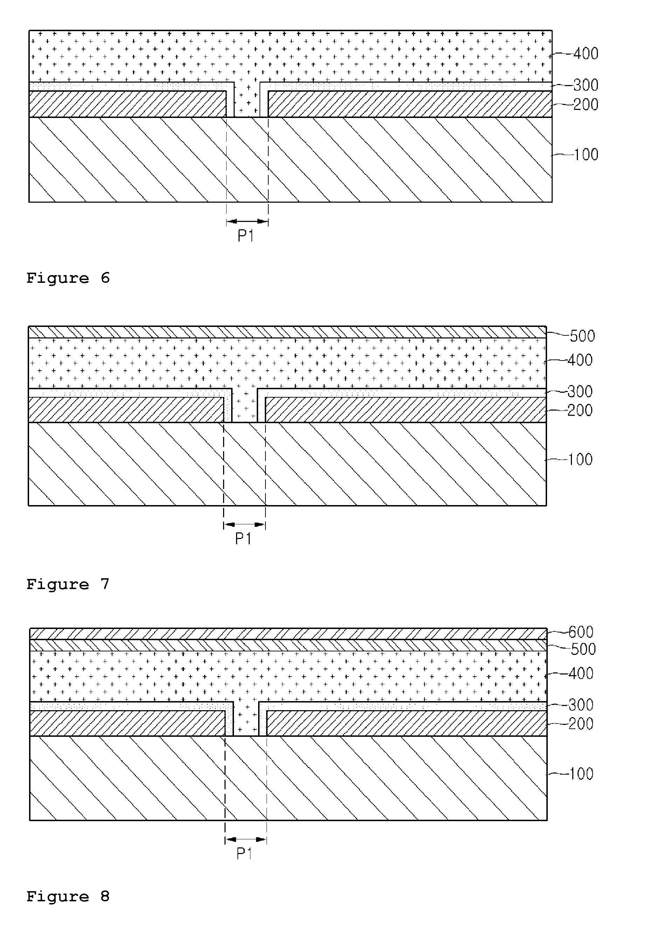

Referring to FIG. 6, the light absorbing layer 400 is formed on the back electrode layer 200 including the first through holes P1. The light absorbing layer 400 receives external light, which is in turn converted into electric energy. The light absorbing layer 400 generates photoelectomotive force by the photovoltaic effect.

The light absorbing layer 400 may include I-III-IV-based compound. In more detail, the light absorbing layer 400 includes the copper-indium-gallium-selenide-based (Cu(In, Ga) Se₂ (CIGS)-based) compounds.

Differently from this, the light absorbing layer 400 may include copper-indium-selenide-based (CulnSe₂ (CIS)-based) compound or copper-gallium-selenide-based (CuGaSe₂ (CIGS)-based) compound.

For example, in order to form the light absorbing layer 400, the CIG-based metal precursor film is formed on the back electrode layer 200 and the first through holes P1 using a copper target, an indium target, and a gallium target.

Thereafter, the metal precursor film reacts with selenium (Se) by a selenization process to form the CIGS-based light absorbing layer.

In addition, the light absorbing layer 400 may be formed by performing a co-evaporation on copper, indium, gallium, selenide (Cu, In, Ga, Se).

The light absorbing layer 400 may be performed under the selenide-based atmosphere in order to quantitative composition of the CIGS compounds.

Therefore, when the selenization process of the light absorbing layer 400 is performed, metal elements forming the back electrode layer 200 and elements forming the light absorbing layer 400 may be coupled with each other by the mutual reaction.

Therefore, the intermediate layer 300 that is intermetallic compound may be formed on the surface of the back electrode layer 200. For example, the intermediate layer 300 may be MoSe₂ that is a compound of molybdenum (Mo) and selenide (Se).

The intermediate layer 300 is formed at the interface at which the light absorbing layer 400 contacts the back electrode layer 200 and may protect the surface of the back electrode layer 200.

The intermediate layer 300 is not formed on the surface of the substrate exposed through the first through holes P1 and thus, the inside of the first through holes P1 may be gap-filled with the light absorbing layer 400.

The MoSe₂ used as the intermediate layer 300 has higher surface resistance than molybdenum that is the back electrode layer 200.

That is, the intermediate layer 300 is formed on the surface of the back electrode layer 200 and thus, the contact resistance of the back electrode layer 200 may be increased. Therefore, the improved contact resistance of the back electrode layer 200 is required.

Referring to FIG. 7, the buffer layer 500 is formed on the light absorbing layer 400.

The buffer layer 500 may be formed on the light absorbing layer in at least one layer. The buffer layer 500 may be made of cadmium sulfide by chemical bath deposition (CBD).

In this case, the buffer layer 500 is an n-type semiconductor layer and the light absorbing layer 400 is a p-type semiconductor layer. Therefore, the light absorbing layer 400 and the buffer layer 500 form a pn junction.

Referring to FIG. 8, a transparent conductive material is deposited on the buffer layer 500 to form the high resistive buffer layer 600. For example, the high resistive buffer layer 600 may be made of at least one of ITO, ZnO, and i-ZnO.

The high resistive buffer layer 600 performs the sputtering process using zinc oxide (ZnO) as a target and may be made of a zinc oxide layer.

The buffer layer 500 and the high resistive buffer layer 600 are disposed between the light absorbing layer 400 and the front electrode to be formed later.

That is, since a difference of a lattice constant and a band gap is large, the light absorbing layer 400 and the front electrode may junctioned well by inserting the buffer layer 500 in which the band gap is positioned at the middle of two materials and the high resistive buffer layer 600.

In the exemplary embodiment of the present invention, two buffer layers 500 and 600 are formed on the light absorbing layer 400, but are not limited thereto and therefore, the buffer layer 500 may be formed of a single layer.

Referring to FIG. 6, a plurality of second through holes P penetrating through the high resistive buffer layer 600, the buffer layer 500, and the light absorbing layer 400 is formed.

The second through holes P2 may expose the intermediate layer 300. The second through holes P2 may be adjacently formed to the first though holes P1. For example, a width of the second through holes P2 may be 80µm±20 and a gap between the second through holes P2 and the first through holes P1 may be 80µm±20.

The second through holes P2 may be formed through the mechanical scribing process using a tip. When the second through holes P2 are formed, the intermediate layer 300 serves as a protective layer of the back electrode layer 200, thereby preventing the defects of the back electrode layer 200.

When the second through holes P2 are formed, the intermediate layer 300 contacting the tip may be selectively crystallized. The reason is that the intermediate layer 300 is selectively heat-treated locally by the tip.

Therefore, the intermediate layer 300 is provided with the second intermediate layer 320 having a different crystal structure. In addition, a portion in which the second intermediate layers 320 in the intermediate layer 300 are not formed may be defined by the first intermediate layers 310. Further, the second intermediate layers 320 have the grain sizes larger than those of the first intermediate layers 310 by being heat-treated by the tip.

In more detail, the intermediate layer may be applied with heat through the tip at the time of the scribing process. For example, the temperature of the tip may be about 400°C to 1000°C.

That is, the second through holes P2 are formed by the tip at the time of the scribing process and at the same time, a portion corresponding to the second through holes P2 in the intermediate layer 300 is heat treated and thus, the second intermediate layers 320 may be formed.

Therefore, the crystallinity of the second intermediate layers 320 may be increased. In particular, the second intermediate layers 320 is grown in a c-axis direction that is a circumference direction by a heat treatment process and the crystallinity of the grain of the second intermediate layer 300 may be higher increased.

Meanwhile, the exemplary embodiment of the present invention describes an example in which the process for forming the second through holes P2 is the mechanical process by the tip, but is not limited thereto. That is, the second through holes P2 form the laser process and then, the second intermediate layers 320 may be formed on the bottom of the second through holes P2 by the local heat treatment process.

As shown in FIG. 3, the grain sizes of the first intermediate layers 310 and the second intermediate layers 320 may be formed differently from each other.

For example, the grain 311 sizes of the first intermediate layers 310 is a first size and the grain 321 sizes of the second intermediate layers 320 may be formed at a second size larger than the first size.

The grains 321 of the second intermediate layers 320 may be formed at a size two to five times than the grains 311 of the first intermediate layers 310.

Therefore, the electric conductivity of the second intermediate layers 320 partially formed in a region of the back electrode layer 200 may be selectively increased.

For example, the first intermediate layers 310 have the first electric conductivity and the second intermediate layers 320 may have the second electric conductivity higher than the first electric conductivity.

The conductivity of the second intermediate layers 320 corresponding to the bottom of the second through holes P2 is selectively high and the thus, the contact characteristics of the back electrode layer 200 can be improved.

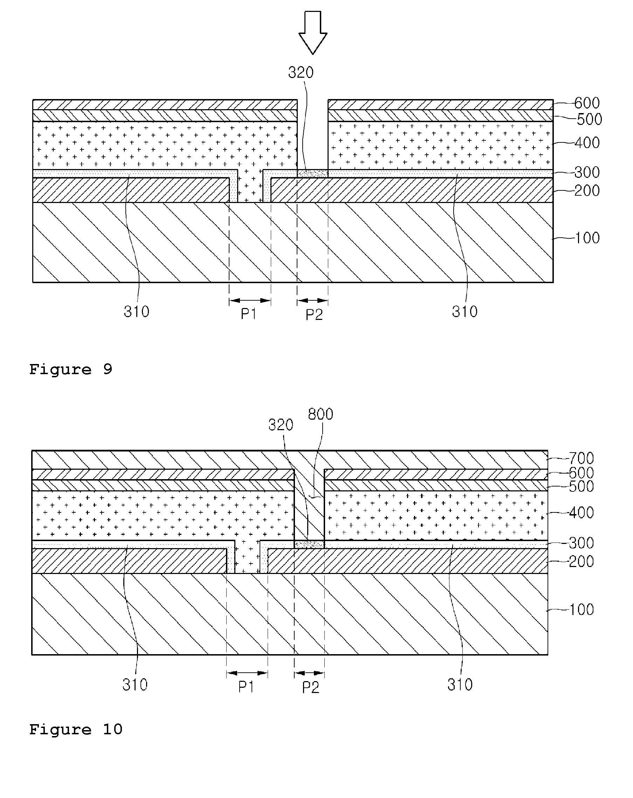

Referring to FIG. 10, the transparent conductive material is stacked on the high resistive buffer layer 600 and the front electrode layer 700 is formed thereon.

When the front electrode layer 700 is formed, the transparent conductive materials may be inserted into the second through holes P2 to form the connection wirings 800.

The connection wirings 800 may be connected with the back electrode layer 200 through the second through holes P2. In particular, the connection wirings 800 may be electrically connected with the back electrode layer 200 by the second intermediate layers 320.

The second intermediate layers 320 may lower the contact resistance of the back electrode layer 200 by the high crystallinity and the expansion of the grain size accordingly.

Therefore, the ohmic contact between the connection wirings 800 and the back electrode layer 200 can be improved. In particular, mobility and conductivity of current flowing the surface of the back electrode layer 200 used as a back contact of the cells C1, C2,... can be improved.

The front electrode layer 700 is made of zinc oxide doped with aluminum (Al) or alumina (Al₂O₃) by the sputtering process.

The front electrode layer 700, which is the front electrode window layer forming the pn junction with the light absorbing layer 400, serves as the transparent electrode on the front surface of the solar cell and may be made of the zinc oxide ZnO having good light transmittance and electric conductivity.

Therefore, the electrode having a low resistance value may be formed by doping the zinc oxide with aluminum or alumina.

The zinc oxide thin film that is the front electrode layer 700 may be formed by depositing a ZnO target by RF sputtering, a reactive sputtering using a Zn target, and organic metal chemical evaporation, or the like.

In addition, a double structrue in which excellent indium tin oxide (ITO) thin film having excellent electro-optical characteristics is deposited on the zinc oxide thin film may also be formed.

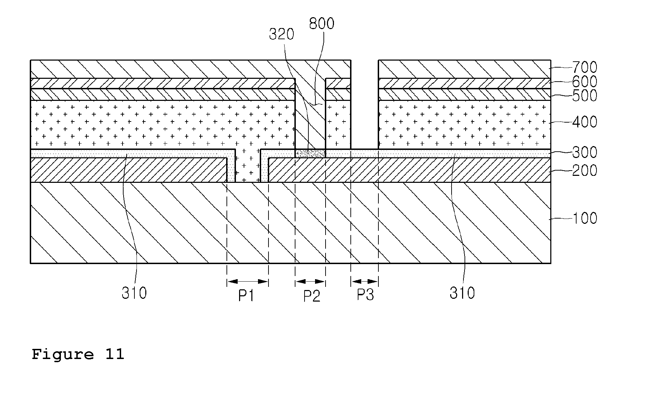

Referring to FIG. 11, the third through holes P3 penetrating through the front electrode layer 700, the high resistive buffer layer 600, the buffer layer 500, and the light absorbing layer 400 is formed.

The third through holes P3 may selectively expose the first intermediate layers 310. The third through holes P3 may be adjacently formed to the second through holes P2.

For example, the width of the third through holes P3 may be 80µm±20 and the gap between the third through holes P3 and the second through holes P2 may be 80µm±20.

The third through holes P3 may be formed by irradiating laser or the mechanical method such as the tip.

When the third through holes P3 are formed, the surface of the back electrode layer 200 may be protected by the first intermediate layers 310.

That is, the first intermediate layers 310 are formed on the surface of the back electrode layer 200 and thus, the first intermediate layers 310 serves as the protective layer of the back electrode layer 200 at the time of the etching process using the laser or tip, thereby preventing the back electrode layer 200 from being damaged.

The light absorbing layer 400, the buffer layer 500, the high resistive buffer layer 600, and the front electrode layer 700 may be separated from each cell by the third through holes P3.

In this case, each cell may be connected with each other by the connection wirings 800. That is, the connection wirings 800 may physically and electrically connect the back electrode layer 200 with the front electrode layer 700 in the cells adjacent to each other.

As described above, the ohmic contact characteristics with the front electrode may be improved by selectively removing the MoSe₂ layer formed on the surface of the back electrode.

In addition, the damage of the back electrode may be prevented by the MoSe₂ layer.

As a result, the electrical characteristics of the photovoltaic generation apparatus according to the exemplary embodiments of the present invention can be improved.

In addition, although the preferred embodiments of the present invention are shown and described above, the present invention is not limited to above-described specific embodiment and is variously modified by one skilled in the art without the gist of the present invention claimed in the claim, such that the modified embodiment is not to be understood separately from technical ideas or views of the present invention.

### Industrial Applicability

The photovoltaic apparatus of the embodiment is used in the photovoltaic industry.

## Claims

1. A photovoltaics apparatus, comprising:
a substrate;
a back electrode layer disposed on the substrate;
a plurality of first intermediate layers disposed on the back electrode layer;
a plurality of second intermediate layers disposed on the back electrode layer and each disposed between the first intermediate layers;
light absorbing layers disposed on the first intermediate layers and the second intermediate layers; and
a front electrode layer disposed on the light absorbing layer.

2. The photovoltaics apparatus of claim 1, wherein the second intermediate layers have electric conductivity larger than the first intermediate layers.

3. The photovoltaics apparatus of claim 2, wherein the light absorbing layer has a plurality of through holes exposing the second intermediate layers.

4. The photovoltaics apparatus of claim 3, further comprising a buffer layer disposed between the light absorbing layer and the front electrode layer,
wherein the through holes penetrate through the buffer layer.

5. The photovoltaics apparatus of claim 3, further comprising a plurality of connection wirings extending from the front electrode layer, each disposed in the through holes, and contacting the second intermediate layers.

6. The photovoltaics apparatus of claim 1, wherein the first intermediate layers and the second intermediate layers are made of the same materials, and
the second intermediate layers have grains larger than the first intermediate layers.

7. The photovoltaics apparatus of claim 6, wherein the grain sizes of the second intermediate layers have two to five times larger than those of the first intermediate layers.

8. A photovoltaics apparatus, comprising:
a substrate;
a first cell and a second cell disposed on the substrate; and
connection wirings connecting a first front electrode of the first cell with the a second back electrode of the second cell,
wherein the second cell includes:
the second back electrode;
a second light absorbing unit disposed on the second back electrode;
a second front electrode disposed on the second light absorbing unit;
a first intermediate layer disposed between the second back electrode and the second light absorbing unit; and
a second intermediate layer disposed between the connection wiring and the second back electrode.

9. The photovoltaics apparatus of claim 8, wherein the second intermediate layer has electric conductivity higher than that of the first intermediate layer.

10. The photovoltaics apparatus of claim 8, wherein the second intermediate layer has a grain size larger than that of the first intermediate layer.

11. The photovoltaics apparatus of claim 8, wherein the first intermediate layer and the second intermediate layer include materials included in the second back electrode and materials included in the second light absorbing unit.

12. The photovoltaics apparatus of claim 8, wherein the connection wiring is connected with the second back electrode through the second intermediate layer.

13. The photovoltaics apparatus of claim 8, wherein the second intermediate layer is directly connected with the connection wiring and the second back electrode.

14. The photovoltaics apparatus of claim 8, wherein the first intermediate layer and the second intermediate layer include the same materials, and
the first intermediate layer and the second intermediate layer have a different crystal structrue.

15. A method for manufacturing a photovoltaics apparatus, comprising:
forming a back electrode layer on a substrate;
forming a light absorbing layer on the back electrode layer;
forming an intermediate layer between the back electrode layer and the light absorbing layer;
forming a through hole penetrating through the light absorbing layer;
a second intermediate layer by crystallizing an intermediate layer exposed by the through hole; and
forming a front electrode layer on the light absorbing layer.

16. The method of claim 15, wherein the first intermediate layer is formed by reacting materials included in the back electrode layer with materials included in the light absorbing layer.

17. The method of claim 15, wherein the second intermediate layer is formed by selectively applying heat to the intermediate layer exposed by the through hole.

18. The method of claim 15, wherein at the forming of the through hole, the light absorbing layer is scribed by using a tip, and
a temperature of the tip is about 400°C to about 1000°C.

19. The method of claim 15, further comprising applying heat to a portion corresponding to the through hole in the intermediate layer while forming the through hole.
